# EUROPEAN PATENT SPECIFICATION

(11) **EP 1 051 802 B1**
(45) Date of publication and mention of the grant of the patent: **18.05.2005**
(21) Application number: 99970218.6
(22) Date of filing: 17.09.1999
(51) Int. Cl.: H03F 3/72, H03D 7/00

(54) **IF AMPLIFIER IN A MIXER OSCILLATOR WITH SYMMETRICAL AND ASYMMETRICAL OUTPUT MODE**
ZF-VERSTÄRKER IN EINEM MISCHER-OSZILLATOR MIT SYMMETRISCHEM UND ASYMMETRISCHEM AUSGANGSMODUS
AMPLIFICATEUR FI DANS UN MELANGEUR-OSCILLATEUR AYANT UN MODE DE SORTIE SYMMETRIQUE ET ASYMMETRIQUE

(30) Priority: 05.10.1998 EP 98203343
(43) Date of publication of application: 15.11.2000
(73) Proprietor: Koninklijke Philips Electronics N.V., 5621 BA Eindhoven (NL)
(72) Inventor: WINK, Meye, NL-5656 AA Eindhoven (NL); CRAND, Olivier, NL-5656 AA Eindhoven (NL)
(74) Representative: Schoenmaker, Maarten
(86) International application number: PCT/EP1999/007014
(87) International publication number: WO 2000/021193

(56) References cited:
- EP-A- 0 147 010
- EP-A- 0 482 336
- DE-A- 19 705 168
- US-A- 4 631 490

## Description

The invention relates to a turner, and to a mixer oscillator integrated circuit.

A tuner and a mixer oscillator integrated circuit are known in the art, and can be used in television receivers, radio receivers, and other applications.

A disadvantage of the known tuner and mixer oscillator integrated circuit is that there have to be two kinds of tuners and mixer oscillator integrated circuits. Namely depending on the output of the tuner, a symmetrical and an asymmetrical version.

An object of the invention is to obtain a tuner and a mixer oscillator integrated circuit that can be used for both symmetrical and asymmetrical outputs. The invention is defined by the independent claims. The dependent claims define advantageous embodiments.

In this way it is possible to use the same tuner or mixer oscillator integrated circuit respectively for both kind of output signals, by switching the IF amplifier between the two modes and by coupling one output of the tuner to ground in the asymmetrical mode.

In the symmetrical output mode on both outputs of the tuner (IF amplifier, mixer oscillator integrated circuit respectively) a signal is present to be handed further. Whereas in the asymmetrical output mode. only on one output an output signal is present and the other output is coupled to ground.

An embodiment of a tuner according to the invention comprises the features of claim 2.

By using a switchable IF amplifier the amplifier itself is switched between the two modes.

Another embodiment of a tuner according to the invention comprises the features of claim 3.

In this embodiment the IF amplifier comprises two amplifying means, one for the symmetrical mode and one for the asymmetrical mode and the control means decide which one has to operate.

The invention and additional features, which may optionally be used to implement the invention to advantage, will be apparent from and elucidated with reference to the examples described below hereinafter and shown in the figures. Herein shows:
Figure 1 a schematic example of a tuner according to the invention, and
Figure 2 a schematic example of an IF amplifier according to the invention.

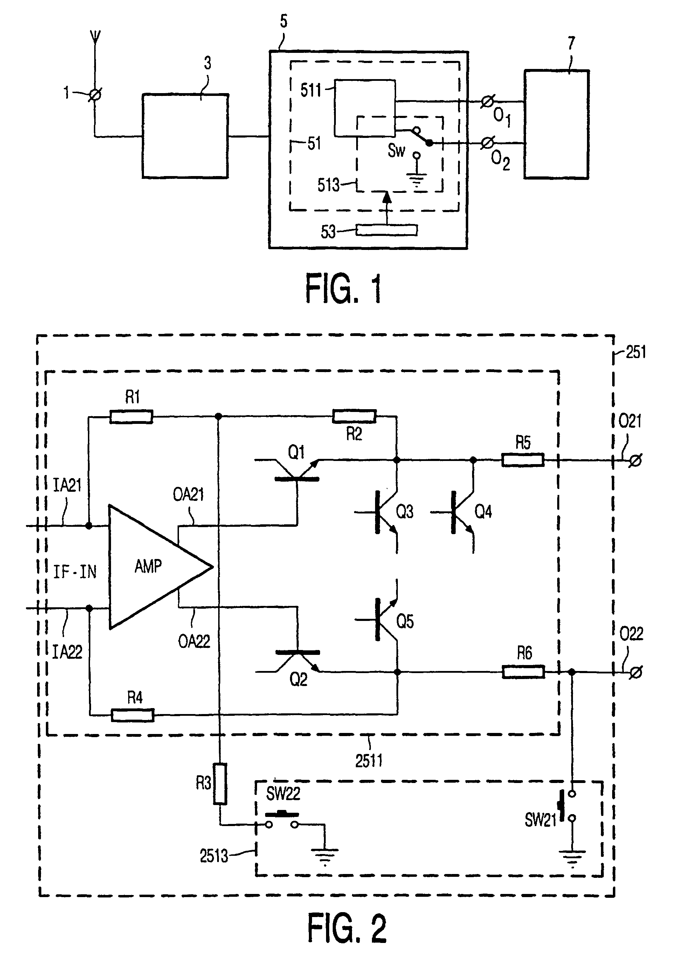

Figure 1 shows a schematic example of a tuner T according to the invention. This tuner comprises an input 1 for receiving an input signal for example from an antenna, the input is coupled to an input circuit 3 for handling the input signal. The input circuit is coupled to a mixer oscillator stage 5 for obtaining and supplying the IF signal. The mixer oscillator stage supplies the IF signal (asymmetrical or symmetrical) via outputs O1 and O2 to a SAW (surface acoustic wave) filter 7 as it is referred to in the art.

A general description of the operation of the tuner T is not necessary as this is generally known to the man skilled in the art.

The mixer oscillator stage 5 comprises in this example a mixer oscillator integrated circuit 51. The mixer oscillator integrated circuit comprises an IF amplifier 511 and switching means 513 and control means 53 for controlling the switching means. It is to be noticed here that the switching means can (partly) be combined with the IF amplifier (as shown in figure 1 by the dashed overlap between IF amplifier 511 and switching means 513).

The switching means 513 operate under control of the control means 53 to switch the IF amplifier between the two modes, that is the symmetrical and the asymmetrical mode. Further the switching means comprise a switch SW to couple one output (O2 in this example) to ground in the asymmetrical mode. In this way it is possible to use the same tuner T, IF amplifier 511 or mixer oscillator integrated circuit 51 respectively for both output signals.

In the symmetrical output mode on both outputs O1 and O2 of the tuner (IF amplifier, mixer oscillator integrated circuit respectively) a signal is present to be handed further. Whereas in the asymmetrical output mode only on one output O1 an output signal is present and the other output O2 is coupled to ground.

Figure 2 shows an example of part of an mixer oscillator integrated circuit 251 according to the invention comprising the IF amplifier 2511 and the switching means 2513. The IF amplifier comprises an amplifying means AMP that receives the IF input signal(s) IF-IN at inputs IA21, IA22. Outputs OA21 and OA22 of the amplifying means are coupled via a transistor Q 1 and a resistor R5, respectively a transistor Q2 and a resistor R6 to the outputs O21 and O22. The transistors Q1 and Q2 are both emitter followers at the output.

The feedback resistors R1, R2, R3 and R4 determine the gain of the IF amplifier 2511, whereby in this example the sum of the values of resistors R1 and R2 corresponds with the value of resistor R4.

In the symmetrical mode switch SW22 of the switching means 2513 is open. In the asymmetrical mode the switch SW22 is closed and the gain is increased in the upper branch. In this way, it is possible to obtain a substantial equal overall gain in both the asymmetrical and the symmetrical mode.

The DC current for the output emitter followers is set by current sources in this example implemented by transistors Q3, Q4 and Q5 as follows:

In the symmetrical mode: Q3 and Q5 provide equal DC currents for Q1 and Q2, Q4 is cut off.

In the asymmetrical mode: Q5 is switched off. Q4 is switched on, doubling the DC current of Q1, compared to the symmetrical mode. This doubling is necessary as is well known to the man skilled in the art, if a minimal dissipation is required. In the symmetrical mode both outputs contain information and the DC current may be about half of the value required when the whole voltage swing is present at only output in the asymmetrical mode.

Instead of one amplifying means as described above the invention can also be implemented with two amplifying means, one for the symmetrical mode and one for the asymmetrical mode. Also in this case one output (O22 in figure 2) is coupled with switching means to ground in the asymmetrical mode.

The man skilled in the art will be well aware of a lot of variations on the above-described examples using the same idea of invention.

For example is it possible, not necessary, to incorporate the control means within the mixer oscillator integrated circuit.

Figure 2 shows a very detailed example of part of the mixer oscillator integrated circuit, which of course is not the only way to implement the IF amplifier for this invention. Further switching means being either totally inside the mixer oscillator integrated circuit or partly inside, partly outside the mixer oscillator integrated circuit, or even totally outside the integrated circuit is possible.

Ground may be any suitable reference voltage.

## Claims

1. A tuner comprising a mixer oscillator stage (5), said mixer oscillator stage comprising an IF amplifier (511), **characterized in that** the mixer oscillator stage further comprises:
switching means (513) for switching the mixer oscillator stage (5) between a symmetrical output mode and an asymmetrical output mode, a first output of said IF amplifier (511) being coupled to a first output (O₁) of the mixer oscillator stage in both output modes, a second output of the IF amplifier being coupled to a second output (O₂) of the mixer oscillator stage in the symmetrical mode, whereas in the asymmetrical mode, said switching means (513) couples the second output (O₂) of the mixer oscillator stage to a reference voltage; and
control means (53) for controlling the switching means (513).

2. The tuner as claimed in claim 1, **characterized in that** the IF amplifier is a switchable IF amplifier.

3. The tuner as claimed in claim 1, **characterized in that** the IF amplifier comprises a first amplifying means and a second amplifying means, whereby the first amplifying means operates in the symmetrical output mode and the second amplifying means operates in the asymmetrical mode.

4. An integrated circuit comprising a mixer oscillator stage (5), said mixer oscillator stage comprising an IF amplifier (511), **characterized in that** the mixer oscillator stage further comprises:
switching means (513) for switching the mixer oscillator stage (5) between a symmetrical output mode and an asymmetrical output mode, a first output of said IF amplifier (511) being coupled to a first output (O₁) of the mixer oscillator stage in both output modes, a second output of the IF amplifier being coupled to a second output (O₂) of the mixer oscillator stage in the symmetrical mode, whereas in the asymmetrical mode, said switching means (513) couples the second output (O₂) of the mixer oscillator stage to a reference voltage; and
control means (53) for controlling the switching means (513).

## Patentansprüche

1. Tuner mit einer Mischoszillatorstufe (5), wobei die genannte Mischoszillatorstufe einen Zf-Verstärker (511) umfasst, **dadurch gekennzeichnet, dass** die Mischoszillatorstufe außerdem Folgendes umfasst:
Schaltmittel (513) zum Umschalten der Mischoszillatorstufe (5) zwischen einem symmetrischen Ausgangsmodus und einem asymmetrischen Ausgangsmodus, wobei ein erster Ausgang des genannten Zf-Verstärkers (511) in beiden Ausgangsmodi an einen ersten Ausgang (O₁) der Mischoszillatorstufe gekoppelt ist, ein zweiter Ausgang des Zf-Verstärkers in dem symmetrischen Modus an einen zweiten Ausgang (O₂) der Mischoszillatorstufe gekoppelt ist, während die genannten Schaltmittel (513) in dem asymmetrischen Modus den zweiten Ausgang (O₂) der Mischoszillatorstufe an eine Referenzspannung koppeln, und
Steuerungsmittel (53) zur Ansteuerung der Umschaltmittel (513).

2. Tuner nach Anspruch 1, **dadurch gekennzeichnet, dass** der Zf-Verstärker ein umschaltbarer Zf-Verstärker ist.

3. Tuner nach Anspruch 1, **dadurch gekennzeichnet, dass** der Zf-Verstärker ein erstes Verstärkungsmittel und ein zweites Verstärkungsmittel umfasst, wobei das erste Verstärkungsmittel in dem symmetrischen Ausgangsmodus arbeitet und das zweite Verstärkungsmittel in dem asymmetrischen Modus arbeitet.

4. Integrierte Schaltung mit einer Mischoszillatorstufe (5), wobei die genannte Mischoszillatorstufe einen Zf-Verstärker (511) umfasst, **dadurch gekennzeichnet, dass** die Mischoszillatorstufe außerdem Folgendes umfasst:
Schaltmittel (513) zum Umschalten der Mischoszillatorstufe (5) zwischen einem symmetrischen Ausgangsmodus und einem asymmetrischen Ausgangsmodus, wobei ein erster Ausgang des genannten Zf-Verstärkers (511) in beiden Ausgangsmodi an einen ersten Ausgang (O₁) der Mischoszillatorstufe gekoppelt ist, ein zweiter Ausgang des Zf-Verstärkers in dem symmetrischen Modus an einen zweiten Ausgang (O₂) der Mischoszillatorstufe gekoppelt ist, während die genannten Schaltmittel (513) in dem asymmetrischen Modus den zweiten Ausgang (O₂) der Mischoszillatorstufe an eine Referenzspannung koppeln, und
Steuerungsmittel (53) zur Ansteuerung der Umschaltmittel (513).

## Revendications

1. Dispositif d'accord comprenant un étage mélangeur-oscillateur (5), ledit étage oscillateur-mélangeur comprenant un amplificateur FI (511), **caractérisé en ce que** l'étage oscillateur-mélangeur comprend encore:
des moyens de commutation (513) pour commuter l'étage mélangeur-oscillateur (5) entre un mode de sortie symétrique et un mode de sortie asymétrique, une première sortie dudit amplificateur FI (511 ) étant couplée à une première sortie (O1) de l'étage mélangeur-oscillateur dans les deux modes de sortie, une seconde entrée de l'amplificateur FI étant couplée à une seconde sortie (O2) de l'étage mélangeur-oscillateur dans le mode symétrique tandis que dans le mode asymétrique lesdits moyens de commutation (513) couplent la seconde sortie (O2) de l'étage mélangeur-oscillateur à une tension de référence; et
des moyens de commande (53) pour commander les moyens de commutation (513).

2. Dispositif d'accord selon la revendication 1, **caractérisé en ce que** l'amplificateur FI est un amplificateur FI commutable.

3. Dispositif d'accord selon la revendication 1, **caractérisé en ce que** l'amplificateur FI comprend des premiers moyens d'amplification et des seconds moyens d'amplification, cas dans lequel les premiers moyens d'amplification fonctionnent dans le mode de sortie symétrique et les seconds moyens d'amplification fonctionnent dans le mode asymétrique.

4. Circuit intégré comprenant un étage mélangeur-oscillateur (5), ledit étage mélangeur-oscillateur comprenant un amplificateur FI (511), **caractérisé en ce que** l'étage mélangeur-oscillateur comprend encore:
des moyens de commutation (513) pour commuter l'étage mélangeur-oscillateur (5) entre un mode de sortie symétrique et un mode de sortie asymétrique, une première sortie dudit amplificateur FI (511) étant couplée à une première sortie (O1) de l'étage mélangeur-oscillateur dans les deux modes de sortie, une seconde entrée de l'amplificateur FI étant couplée à une seconde sortie (O2) de l'étage mélangeur-oscillateur dans le mode symétrique tandis que dans le mode asymétrique lesdits moyens de commutation (513) couplent la seconde sortie (O2) de l'étage mélangeur-oscillateur à une tension de référence; et
des moyens de commande (53) pour commander les moyens de commutation (513).
